Europäisches Patentamt

European Patent Office

Office européen des brevets

(11) Numéro de publication: **0 016 976**
A1

## (12) DEMANDE DE BREVET EUROPEEN

(21) Numéro de dépôt: **80101046.3**

(51) Int. Cl.³: **H 03 H 9/48,** H 03 H 9/24

(22) Date de dépôt: **03.03.80**

(30) Priorité: **08.03.79 FR 7905972**

(43) Date de publication de la demande: **15.10.80**
**Bulletin 80/21**

(84) Etats contractants désignés: **AT BE CH DE FR GB IT NL SE**

(71) Demandeur: **COMPAGNIE GENERALE D'ELECTRICITE Société anonyme dite:, 54, rue La Boétie, F-75382 Paris Cedex 08 (FR)**

(72) Inventeur: **Duchet, Christian, 76 rue Alfred Dubois, F-91460 Marcoussis (FR)**

(74) Mandataire: **Weinmiller, Jürgen et al, Zeppelinstrasse 63, D-8000 München 80 (DE)**

(54) **Dispositif piézoélectrique composite résonnant à basse fréquence.**

(57) La fréquence de résonnance est abaissée, sans diminution du facteur de couplage, et malgré la longueur limitée des plaquettes piézoélectriques, grâce à la présence de plusieurs plaquettes piézoélectriques (4) se succédant selon la longueur d'au moins une face d'une lame métallique (2) qui les supporte.

Application aux résonateurs électriques.

ACTORUM AG

## Dispositif piézoélectrique composite résonnant à basse fréquence

L'invention concerne un dispositif piézoélectrique composite résonnant à basse fréquence, comportant :

- une lame métallique,
- une plaquette piézoélectrique soudée par une face sur au moins une face de cette lame,
- une métallisation sur la face opposée de cette plaquette,
- des bornes de connexion pour connecter à l'extérieur d'une part cette lame et d'autre part cette métallisation.

Un tel dispositif peut être un transducteur ou un résonateur : Un transducteur piézoélectrique convertit l'énergie électrique en énergie mécanique et réciproquement. Il possède au moins un accès électrique et un accès mécanique. Lorsque l'accès mécanique n'est pas utilisé, un transducteur devient un résonateur.

Un résonateur piézoélectrique peut toujours, autour de la fréquence de résonance, être représenté par un circuit à quatre éléments (L1 ; inductance, C1 : capacité en série avec L1, R1 : résistance en série avec L1, $C_o$ : capacité en parallèle avec le circuit L1, C1, R1).

Les caractéristiques électriques du résonateur sont entièrement déterminées par la connaissance des éléments Co, L1, C1 et R1 ou par les quantités fr, k, Co, Q avec

$$Pr = 2\ pi.fr$$

$$(Pr)^2 = \frac{1}{L1.C1}$$

$$k^2 = \frac{C1}{Co} \text{ voisin de } \frac{2\,(f_a - f_r)}{f_r}$$

$$Q = \frac{Pr\ L1}{R1}$$

(Pr : pulsation de résonance
(fr : fréquence de résonance,
(pi : rapport du périmètre au diamètre du cercle
(k : facteur de couplage électromécanique,
(
(fa : fréquence d'antirésonance)
(Q : Facteur de qualité.)

Le facteur de couplage $k^2$ est une caractéristique importante car il indique la largeur maximale de la bande passante relative qui peut être réalisée quand les résonateurs sont utilisés dans des filtres électriques.

Une caractéristique importante d'un résonateur est le coefficient de température de la fréquence de résonance (CTF) défini par

$$CTF = \frac{1}{fr} \cdot \frac{dfr}{dT} \qquad (\text{en } °C^{-1})$$

où T est la température.

Le niveau d'impédance d'un résonateur est déterminé par Pr L1 qui s'écrit

$$PrL1 = \frac{1}{PrCok^2}$$

A fréquence donnée le niveau d'impédance dépend de Co et de $k^2$.

Il existe une grande variété de résonateurs utilisant de nombreux modes de vibration. En basse fréquence deux classes importantes sont celles des structures vibrant en mode longitudinal avec excitation transversale et celle des structures vibrant en flexion, également avec excitation transversale.

Les caractéristiques électriques du résonateur sont déterminées par ses dimensions et ses propriétés piézoélectriques. On peut prendre l'exemple d'un résonateur parallèlipipédique simple à vibration longitudinale et excitation transversale et dont l'épaisseur est $e_p$ (distance entre les deux électrodes minces), la largeur $w_p$ et la longueur $l_p$.

Il vient

$$fr = \frac{c_p}{2\, l_p} \;;$$

où $c_p$ est la vitesse de propagation de l'onde acoustique dans le matériau piézoélectrique ;

$$k^2 = \frac{8}{pi^2} \cdot \frac{k_{31}^2}{1-k_{31}^2} \;;$$

où $k_{31}$ est le facteur de couplage du matériau piézoélectrique pour la direction d'excitation 3 (épaisseur) et la direction de déplacement 1 (longueur) ;

$$Co = E_{33}^t (1-k_{31}^2) \frac{w_p l_p}{e_p} , \qquad (E_{33}^t \text{ désignant la constante diélectrique du matériau dans les conditions considérées.})$$

On sait aussi réaliser un résonateur composite constitué par un assemblage rigide d'un matériau piézoélectrique et d'un métal (ou d'un autre matériau). Un tel résonateur présente l'avantage de pouvoir être compensé en température, c'est-à-dire de permettre, en ce qui concerne l'influence de la température sur la fréquence de résonance, de compenser les variations dues au matériau piézoélectrique par celles dues au métal.

Un bon résonateur est caractérisé par :

- Q grand
- CTF faible
- $k^2$ grand
- Pr L1 petit.

Les résonateurs simples en quartz possèdent les deux premieres caractéristiques mais pas les deux dernières.

Avec des résonateurs composites il est possible d'avoir ces quatre caractéristiques.

Le niobate de lithium de coupe 47°Y possède un grand facteur de couplage $k_{31}$ (avantage) et un fort CTF négatif (inconvénient).

Par son association à un métal, de CTF opposé, il est possible d'avoir un résonateur composite compensé en température tout en ayant un facteur de couplage important.

Une structure composite est de fabrication plus complexe qu'une structure simple mais elle présente une grande souplesse dans les performances et dans la réalisation de circuits comportant un ou plusieurs résonateurs.

Selon la disposition adoptée un résonateur peut présenter des modes de flexion et des modes longitudinaux (ou "d'extension").

Les dispositifs connus présentent les inconvénients suivants :
- d'une part leur fréquence ne peut pas descendre au-dessous de
certaines valeurs sans diminuer trop fortement les facteurs de couplage
(c'est-à-dire notamment la largeur de bande d'un filtre). Ces valeurs
sont par exemple 100 kHz en élongation et 40 kHz en flexion. On
ne peut descendre au-dessous qu'en augmentant la longueur du seul
métal, au détriment du facteur de couplage.

Si, pour conserver un bon facteur de couplage on veut augmenter
aussi la longueur du matériau piézoélectrique on est limité par
la longueur des plaquettes disponibles.

De plus, lorsqu'on est amené ainsi à choisir la plus grande
longueur disponible de ces plaquettes, le prix de la plaquette devient
gênant.

La présente invention a pour but la réalisation d'un dispositif
piézoélectrique composite résonnant à basse fréquence permettant
d'abaisser la fréquence de résonance sans diminuer le facteur de
couplage et en conservant un prix acceptable.

Elle a pour objet un  dispositif piézoélectrique composite
résonnant à basse fréquence comportant
- une lame métallique
- une plaquette piézoélectrique soudée par une face sur au moins
une face de cette lame
- une métallisation sur la face opposée de cette plaquette
- des bornes de connexion pour connecter à l'extérieur d'une part
cette lame et d'autre part cette métallisation,
caractérisé par le fait que plusieurs plaquettes piézoélectriques
ainsi soudées et métallisées, séparées les unes des autres se succèdent
sur une même face de cette lame, des connexions souples reliant entre
elles les métallisations des plaquettes successives.

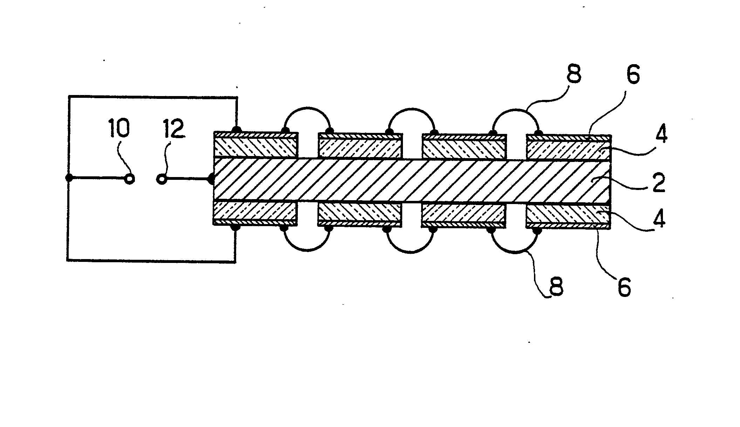

A l'aide de la figure schématique unique ci-jointe, on va décrire
ci-après, à titre non limitatif, un mode de mise en oeuvre de l'invention.

La figure représente une vue en coupe d'un dispositif selon
l'invention, le plan de coupe étant longitudinal.

La longueur d'un résonateur est généralement limitée par la
taille du matériau piézoélectrique.

Or, avec un résonateur composite, il est possible de fractionner le matériau piézoélectrique car il existe un support mécanique et la fréquence est alors abaissée en conservant la même longueur pour les plaquettes piézoélectriques individuelles (longueur maximale $l_{max}$) et le même rapport des sections de matériau piézoélectrique et de métal (compensation en température et facteur de couplage électromécanique).

Si, pour un résonateur composite à une seule plaquette de longueur $l_{max}$, la fréquence est fo en extension et f1 en flexion, pour un résonateur composite de n plaquettes, chacune de longueur unitaire $l_{max}$ la fréquence est :

fo/n pour le mode d'extension,

$f1/n^2$ pour le mode de flexion,

si on suppose que les sections sont inchangées et que les longueurs du métal et du matériau piézoélectrique gardent le même rapport.

Le dispositif décrit est un résonateur qui fonctionne en élongation. Il est constitué par une lame métallique 2 sur chacune des deux faces de laquelle ont été soudées plusieurs plaquettes 4 de matériau piézoélectrique, de manière à occuper toute la longueur de la lame 2 tout en laissant des intervalles entre les plaquettes adjacentes. Les faces extérieures 6 de ces plaquettes sont métallisées comme connu, et connectées électriquement les unes aux autres par des fils d'or ou d'aluminium 8, de 50 microns de diamètre, soudés par thermocompression. La connexion électrique au réseau extérieur se fait entre des bornes 10 et 12, connectées respectivement l'une aux métallisations extérieures des plaquettes 4, l'autre à la lame 2.

A titre d'exemple plus particulier on peut donner les précisons suivantes :

- composition de la lame 2 - Alliage thermocompensable de type connu
- son épaisseur : 3 mm
- sa largeur : 3 mm
- sa longueur : 44 mm
- composition des plaquettes 4 : niobate de lithium
- leur épaisseur : 0,5 mm
- leur largeur : 3 mm

- leur longueur : 11 mm
- intervalles entre deux plaquettes : 0,1 mm
- nature de la soudure : Pb - Sn
- nature de la métallisation des faces 6 : Ni-Cr-Au
- son épaisseur : 1 micromètre
- fréquence de résonance : 55 kHz

Si l'on désire réaliser un quadripole, ou plus généralement un multipole (pour constituer par exemple une cellule d'un filtre), il est possible de prévoir, sur les faces extérieures des plaquettes 6, des bandes longitudinales étroites non métallisées de manière à laisser subsister plusieurs bandes longitudinales métallisées isolées les unes des autres, les métallisations d'une même bande sur les plaquettes successives étant connectées entre elles. La lame métallique constitue alors une masse commune, les bandes métallisées qui se succèdent dans la largeur du dispositif étant connectées à des bornes distinctes.

REVENDICATIONS

1/ Dispositif piézoélectrique composite résonnant à basse fréquence comportant

- une lame métallique (2),

- une plaquette piézoélectrique (4) soudée par une face sur au moins une face de cette lame

- une métallisation (6) sur la face opposée de cette plaquette,

- des bornes de connexion pour connecter à l'extérieur d'une part cette lame et d'autre part cette métallisation,

caractérisé par le fait que plusieurs plaquettes piézoélectrique ainsi soudées et métallisée séparées les unes des autres, se succèdent sur une même face de cette lame (2), des connexions souples (8) reliant entre elles les métallisations (6) des plaquettes successives (4).

2/ Dispositif selon la revendication 1, caractérisé par le fait que des plaquettes piézoélectriques (4) ainsi soudées et métallisées sont disposées symétriquement sur les deux faces de la lame (2) de manière à faire travailler le dispositif en mode d'extension.

3/ Dispositif selon la revendication 1, caractérisé par le fait que les métallisations (6) des plaquettes (4) forment, dans la largeur du dispositif, une succession de bandes métallisées longitudinales isolées les unes des autres, avec des connexions souples (8) entre les métallisations d'une même bande sur les plaquettes successives, de manière à réaliser un multipole.

Office européen
des brevets

**RAPPORT DE RECHERCHE EUROPEENNE**

0016976
Numéro de la demande

EP 80 10 1046

| | **DOCUMENTS CONSIDERES COMME PERTINENTS** | | **CLASSEMENT DE LA DEMANDE (Int. Cl. ³)** |
|---|---|---|---|
| Catégorie | Citation du document avec indication, en cas de besoin, des parties pertinentes | Revendication concernée | |
| | GB - A - 1 105 114 (KOKUSAI DENKI KABUSHIKI KAISHA) <br><br> * Page 1, lignes 14-28; page 2, ligne 47 - page 3, ligne 2; page 5, lignes 4-32; figures 1a, 1b, 5a * <br><br> -- | 1,3 | H 03 H 9/48 <br> 9/42 |
| | US - A - 3 614 485 (COSMAN et al.) <br><br> * Colonne 1, ligne 72 - colonne 4, ligne 61; figures 1,2,3 * <br><br> -- | 1 | |
| | ELECTRONICS AND COMMUNICATIONS IN JAPAN, vol. 51-A, no. 9, septembre 1969 <br> Tokyo JP <br> TOMIKAWA et al.: "Electromechanical filters consisting of longitudinal - and bending - resonance mode vibrators", pages 1-8. <br><br> * Page 1, colonne de droite, ligne 11 - page 2, colonne de gauche, ligne 11; figure 1 * <br><br> -- | 1,2 | **DOMAINES TECHNIQUES RECHERCHES (Int. Cl. ³)** <br><br> H 03 H 9/24 <br> 9/48 <br> 9/58 <br> 9/60 <br> 9/50 <br> 9/52 <br> 9/46 |
| | FR - A - 1 577 131 (SHIGERU KAKU-BARI) <br><br> * Page 7, ligne 8 - page 8, ligne 37; figures 12,13 * <br><br> -- | 1 | |
| | IEEE TRANSACTIONS ON CIRCUITS AND SYSTEMS, vol. CAS-22, no. 2, février 1975 <br> New York US <br> D.F. SHEAHAN et al.: "Crystal and mechanical filters", pages 69-89 <br><br> * Page 75, colonne de droite, <br> ./. | 1 | **CATEGORIE DES DOCUMENTS CITES** <br><br> X: particulièrement pertinent <br> A: arrière-plan technologique <br> O: divulgation non-écrite <br> P: document intercalaire <br> T: théorie ou principe à la base de l'invention <br> E: demande faisant interférence <br> D: document cité dans la demande <br> L: document cité pour d'autres raisons |

&: membre de la même famille, document correspondant

Le présent rapport de recherche a été établi pour toutes les revendications

| Lieu de la recherche | Date d'achèvement de la recherche | Examinateur |
|---|---|---|
| La Haye | 13-06-1980 | DHONDT |

OEB Form 1503.1 06.78

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendica-tion concernée | |
| | ligne 7 - page 76, colonne de droite, ligne 15; figures 8,9, figure 19 *  ---- | | |
| | | | **DOMAINES TECHNIQUES RECHERCHES (Int. Cl. 3)** |